# EUROPEAN PATENT SPECIFICATION

(11) **EP 4 440 269 B1**
(45) Date of publication and mention of the grant of the patent: **26.02.2025**
(21) Application number: 23020163.4
(22) Date of filing: 29.03.2023
(51) Int. Cl.: H05K 7/20

(54) **CYLINDRICAL RACK CABINET**
ZYLINDRISCHER RACKSCHRANK
ARMOIRE À ÉTAGÈRES CYLINDRIQUE

(43) Date of publication of application: 02.10.2024
(73) Proprietor: Cristea, Mihai-Lucian, 800198 Galati (RO)
(72) Inventor: Cristea, Mihai-Lucian, 800198 Galati (RO)

(56) References cited:
- EP-A2- 0 447 819
- CN-A- 107 449 052
- CN-A- 113 015 403
- US-A1- 2017 126 054
- US-A1- 2022 124 934

## Description

### TECHNICAL FIELD

The present disclosure generally relates to handling and cooling systems and methods for cooling electronic components and more precisely relates to a rack-mounted cabinet with efficient size occupancy, ergonomic handling of the electronic devices and their connectivity wires, and power saving. In particular, the present disclosure shows how electronic devices can sit in a cylindrical rack cooling structure.

### BACKGROUND

Electronic equipment may generate a substantial amount of heat during operation. In order to keep this equipment operating effectively and reliably, it is necessary to cool the equipment by removing the excessive heat. Failure to do so may result in component failure and possibly fire.

While cooling systems are necessary for many types of electronic equipment, one area in which they are perceived to be critical is computer applications in commercial, industrial or military fields. The present invention relates primarily to cooling computer equipment and the remainder of this discussion will focus on the same.

Various techniques are known for removing heat energy including natural convection air; forced air; cold plates (cooled masses that are in contact or in close proximity to the heat generating device); and direct contact liquid cooling. While all these methods have distinct advantages, forced air cooling is often the method of choice for cooling and electronic device or a computer equipment.

Forced air cooling is advantageous over other cooling methods for several reasons. First, forced air cooling devices are generally simple to integrate into the computer enclosure. Additionally, these devices are commercially available in a wide variety of sizes and are thus cost effective. Furthermore, forced air cooling devices have proven to be highly reliable.

Even with these advantages though, forced air cooling does have limitations. To explain, removal of a specific quantity of heat energy from a computer system utilizing forced air cooling requires a computer designer to predict the thermal resistance of the moving air and the temperature differential between the air stream and the device to be cooled.

Document JP2004055883A discloses a rack comprising a suction duct provided so that the opening cross-sectional area becomes narrower as the pair of left and right suction ducts are separated from the intake fan. However, there are shortcomings caused by the rectangular shape cabinet, which is a limitation to the number of computers and a complexity caused by the use of many individual fans.

Document JP2010153526A discloses a rack mounted cabinet including a box-like body part and a tubular air duct provided upright at its central portion. In the cabinet, computers are arranged, divided in two groups, in multiple stages on both sides of the air duct. The chilled air introduced into the lower section of the air duct rises, and during an air rise, it is blown to the computers through an exhaust opening provided in the air duct. Thus, a CPU, RAM, and other electronic components that are heated and mounted on the computers are effectively cooled. The air that has cooled the CPU, RAM, and the like is exhausted from the side surface of the body part of the cabinet. However, there are shortcomings caused firstly by the hot air, which is evacuated in the room around the cabinet, thus the room gets hotter affecting the other cabinets. There is a limit of only 2 computers and the use of fan units on each level.

Document US6167947B1 discloses a cooling system based on high elevation requirements comprising a computer system. The system comprises a generally cylindrical, hollow upper body portion and a mating lower body portion. The system may further comprise a base to accommodate various components as further described below. The upper portion lowers to mate with the lower portion in a closed position, forming a sealed compartment or volume therein. When the system is closed, an upper plenum is formed by a door that closes over a front side of the chassis and fluidly couples the front side of the chassis to the lower plenum. Thus, a generally sealed pathway is formed between the chassis and the blower. However, there are shortcomings caused by the complexity of the disclosed solution by using nitrogen cooling. Furthermore, the hosting of very few horizontal computer boards is a limiting factor. Also, the access to modules is difficult in case one needs to replace them.

Document US8867204B1 discloses a datacenter or server farm having servers mounted to blow air at an angle in a hot aisle. The angled air flow can provide a cyclonal effect in the hot aisle, enhancing heat convention in the hot aisle, server rack in the modular datacenter. However, the solution refers to a complete datacenter building, not to a specific server rack.

Further similar devices are disclosed in US 2022/124934A1 and CN 113 015 403 A.

The document CN107449052A shows a cooling structure having a central inlet duct, from where cooling air is guided through radially arranged electronic equipment, and which is then collected as hot air in an exterior duct.

Document JP2012048548A discloses a ceiling of the air conditioning chamber, at least one outlet for blowing the conditioned air (cold air) from the air conditioner vertically downward. This blower outlet is connected with the air-conditioning air blower outlet of an air conditioner via the blowout duct. However, there are shortcomings caused by the complexity of the design with a small fan in each server and the hot air is circulated in the longitudinal central part of the datacenter room.

Document JP2004023036A discloses an electronic apparatus housing rack provided with a cooling system, has the electronic apparatuses mounted on each of a plurality of shelves arranged at a distance in vertical directions, and is provided with the cooling system in a rack, having a ventilation port at the top portion. The housing rack comprises a duct provided in vertical directions of the rack; fans that take in cool air to supply into the duct; and nozzles, which are arranged for each shelf and on which air outlet ports are formed, in which the nozzles are communicated to the duct, and the nozzles blow out the cool air sucked by the fans toward the electronic apparatuses. However, there are shortcomings caused by complexity of the electronic apparatuses positioning horizontally, in a rectangular cabinet.

### BRIEF DESCRIPTION OF THE DRAWINGS

It will be appreciated that for simplicity and clarity of illustration, elements illustrated in the Figures are not necessarily drawn to scale. For example, the dimensions of some elements may be exaggerated relative to other elements. Embodiments incorporating teachings of the present disclosure are shown and described with respect to the drawings herein, in which:
**Figure 1.** Figure 1 shows the rack according to an embodiment of the present disclosure.
**Figure 2.** Figure 2 illustrates details of the rack according to an embodiment of the present disclosure.
**Figure 3.** Figure 3 presents details of the rack according to an embodiment of the present disclosure.

### DETAILED DESCRIPTION

The following description in combination with the Figures is provided to assist in understanding the teachings disclosed herein. The description is focused on specific implementations and embodiments of the teachings and is provided to assist in describing the teachings. This focus should not be interpreted as a limitation on the scope or applicability of the teachings, with the scope of the invention being defined by the appended claims:

In the embodiments described herein, a rack or a cabinet that is provided with handling, connecting and cooling system includes any instrumentality or aggregate of instrumentalities operable to host, handle, operate, cool, compute, classify, process, transmit, receive, retrieve, originate, switch, store, display, manifest, detect, record, reproduce, handle, or use any form of electronic device or software in the form of information, intelligence, or data for business, scientific, control, entertainment, or other purposes. For example, an electronic device can be an industrial computer, a programmable logic controller (PLC), a personal computer, a consumer electronic device, a server or storage device, a switch or router, wireless router, or other network communication or computation device based on electronic, light or quantum technologies, a network connected device (cellular telephone, tablet device, etc.), one or more processing resources, such as a central processing unit (CPU), a graphics processing unit (GPU), hardware or software control logic, or any combination thereof or any other suitable device, and can vary in size, shape, performance, price, and functionality.

Some examples are now described in more detail with reference to the enclosed figures. However, other possible examples are not limited to the features of these examples described in detail. Other examples may include modifications of the features as well as equivalents and alternatives to the features as long as they fall within the scope defined by the appended claims.

Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification

When two elements A and B are combined using an 'or' , this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include" , "including" , "comprise" and/or "comprising" , when used, describe the presence of the specified features, integers, steps, operations, processes, elements, components and/or a group thereof, but do not exclude the presence or addition of one or more other features, integers, steps, operations, processes, elements, components and/or a group thereof.

In the following description, various embodiments will be described. For purposes of explanation, specific configurations and details are set forth in order to provide a thorough understanding of the embodiments. However, it will also be apparent to one skilled in the art that the embodiments may be practiced without the specific details. Furthermore, well-known features may be omitted or simplified in order not to obscure the embodiment being described.

The present invention relates to a rack mount cabinet on which a plurality of electronic devices can be mounted in a coolable manner and a way to wire the interfaces of the electronic devices to the external world.

In order to achieve the above objective, the present invention provides a main body portion in which a plurality of electronic devices are mounted, and one end serving as an air intake port, and a plurality of air leadings from the one end to the plurality of electronic devices. There is provided a rack mount cabinet characterized in that an interface is provided to face the mounting position of the electronic device, and a wind tunnel is provided inside the main body.

According to this invention, the cooling efficiency of the electronic device mounted inside can be improved and thus, power saving and space saving can be achieved.

The rack cooling structure of the invention can be standalone in a room, which can be for instance an office or a house living room. The cylindrical general shape can be attractive; therefore, the rack can also be used as a piece of art in a house, office, hotel or other similar.

The rack cooling structure of the invention can also be part of an industrial control room facility for smart factories. Several such racks can be located within a control room in which people may work around. All wirings for power and data signals go underfloor and heating goes over the ceil, allowing engineers to quickly monitor, eventually replace devices from the rack.

The rack cooling structure of the invention can also be part of a datacenter. A datacenter is a facility used to house a collection of electronic devices or computer servers and associated components, typically network hardware. The collection of computer servers is often called a "server cluster" or "server farm," and is designed to accomplish server needs far beyond the capability of a single machine. The networking hardware typically includes network switches and/or routers which enable communication between the different parts of the server farm and the users of the server farm. Server farms are commonly used for cluster computing, web services, remote data storage, web hosting, and other web services. Server farms are increasingly being used by enterprises instead of, or in addition to, mainframe computers. As the demand for server farms continues to increase, a need exists to limit the cost of operating a datacenter. Often, a large part of the cost of operating a datacenter is related to the datacenter's cooling systems and the total electricity cost. To this end, enterprises typically try to maximize power usage effectiveness (PUE) of a datacenter, which is a measure of how efficiently a computer datacenter uses its power; specifically, how much of the power is actually used by the computing equipment in contrast to cooling and other overhead. In one example, the datacenter includes several floors, each floor or level equipped with a cold air source in the floor and a hot air evacuation duct in the ceiling.

In an embodiment, cold air source in the floor and a hot air evacuation duct are in the form of tubes.

In the rack itself, the main structure and the air flow ducts can mainly be in the shape of a cylinder. As used herein, a "cylinder" is a continuous structure, such as a wall, that encloses a space. In embodiments herein, the cylinders are aligned vertically so as to form vertical ducts.

The cold air source may include a vent for drawing ambient air from outside the room. In addition, or alternatively, cooled air may be provided, for example from a chilling tower, that can be introduced into the cold air source.

The exhaust hot air can be further used to warm up various facilities or spaces.

The electronic devices or computers may be mounted on specially designed racks that mount into interfaces. These interfaces may be formed by removing dummies or punch-out plates. In embodiments, the racks are configured so that the computer devices mount in a vertical fashion, instead of the typical horizontal fashion, allowing the footprint of the computer devices to be narrower in width. Narrower footprints allow more computers to be staggered, permitting a more efficient use of the space and providing a better cooling effect.

The electronic devices or computers that are mounted vertically can be mounted in specially designed interfaces. In embodiments, a clip system and / or a screw is provided for releasing and locking a computer device onto the computer interface. In addition, dummy cover panels may be provided for filling in one of the computer slots when a computer is removed, for example, when the computer is under repair. These panels can prevent air flow bypass between hot and cold zones when a computer is removed from the rack.

In embodiments, computing devices are arranged so that they draw air from a cold zone and exhaust air into a hot zone. For example, a rack may be mounted so that they extend through a wall that separates a cold zone and a hot zone.

In an embodiment, the present invention can provide a cooling module based on the water-cooling method and / or a cooling fin based on the forced air-cooling system. This can enhance the cooling methods for the respective computers or electronic devices. It is thus possible to use common components for the modules other than the cooling module. Alternatively, an air conditioner might be used to enhance the cooling effect.

In accordance with the above-mentioned objectives, the disclosed heat dissipation module can include a base, several fins, a fan, and a Stirling engine. The base can be disposed on a heat removing device. Fins can be connected with the base, within or outside the air ducts. The fan blows towards the fins. The Stirling engine has a power inlet disposed on the base and a power outlet connected with the fan. The Stirling engine is utilized to remove the heat from the heat source using the heat generated thereby.

The invention is defined by the features of claim 1. Further embodiments are defined in the dependent claims.

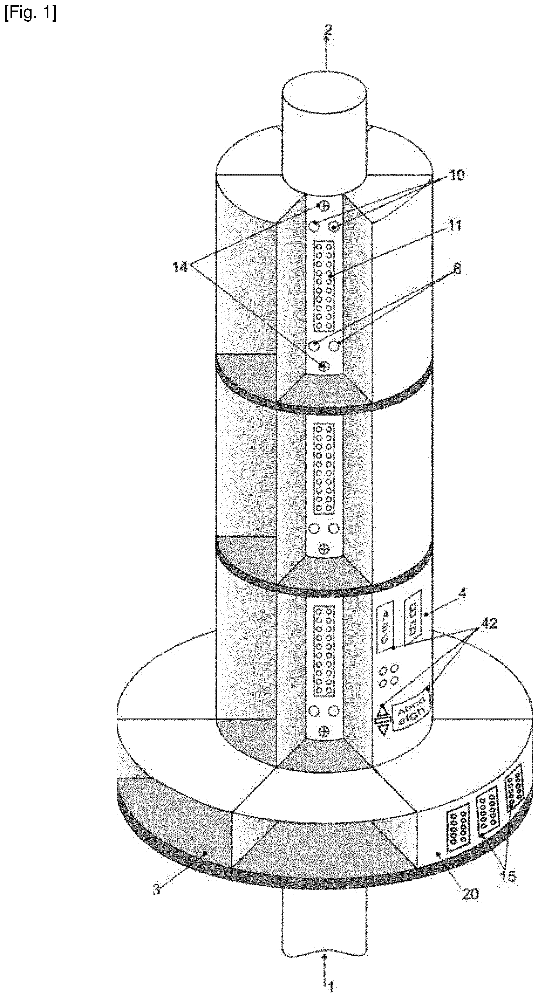

In detail, the rack cooling structure of the invention comprises an air intake (1) connected to an air inlet tube (6) of substantially cylindrical shape having a diameter D61. The air intake (1) can be in the shape of an air arrival duct and can be situated underneath the rack, as it can be seen in Fig 1. The air inlet tube (6) can be typically a rectilinear tube.

The rack cooling structure of the invention comprises also an air exhaust (2) connected to an air outlet tube (7) of substantially cylindrical shape having a diameter D71. The air exhaust (2) can be a flexible air duct, situated in the upper extremity of the rack, as seen in Fig 1. The air exhaust (2) can be directly arranged in the sealing of the room where the rack is installed, can be connected with a lateral wall in case hot air is evacuated outside the room or the building or can be connected to another device designed to reuse the heat. The air outlet tube (7) can be typically a rectilinear tube.

The rack cooling structure of the invention comprises also at least one base segment (3) having a substantially cylindrical shape with a diameter D31. In an embodiment there can be one base segment (3), as seen on Fig 1. All the base segments (3) have preferably a similar diameter and a similar thickness. The base segments (3) can be juxtaposed in a modular and superposition manner. Depending on how many connectors are used to interface the entire rack with external world, the number of superposed base segments (3) can be increased. In other embodiments two, three or more base segments (3) can be superposed, depending on the need.

The rack cooling structure of the invention comprises also at least one connecting segment (5) having a substantially cylindrical shape with a diameter D51, the said diameter D51 being the exterior diameter of connecting element (5). In an embodiment, there can be any number of superposed connecting segments (5), for instance three superposed connecting segments (5), as seen on Fig 1. Each connecting segment (5) has preferably a similar diameter and a similar thickness to each other. The connecting segments (5) can be juxtaposed in a modular and superposition manner. Depending on how many electronic devices and their sizes need to accommodate in a rack, the number of superposed connecting segments (5) can usually vary between 1 and 6, as visible in Fig 1. In an embodiment the number of connecting segments (5) can be increased to 12, 20 or more. The number of superposed connecting segments (5) and the number of superposed base segments (3) can be independently chosen one from the other. The number of connecting segments (5) and the number of base segments (3) can be chosen according to the requirements in amount of electronic devices need be hosted in the rack and the number of wirings they need to interface to the external world, respectively. Alternatively, the rack's modularity can be set as a ratio between the number of superposed connecting segments (5) and the number of superposed bases (3). In one example of this alternative, the ratio between the number of superposed connecting segments (5) and the number of superposed bases (3) can be three to one, as it can be seen in Fig 1.

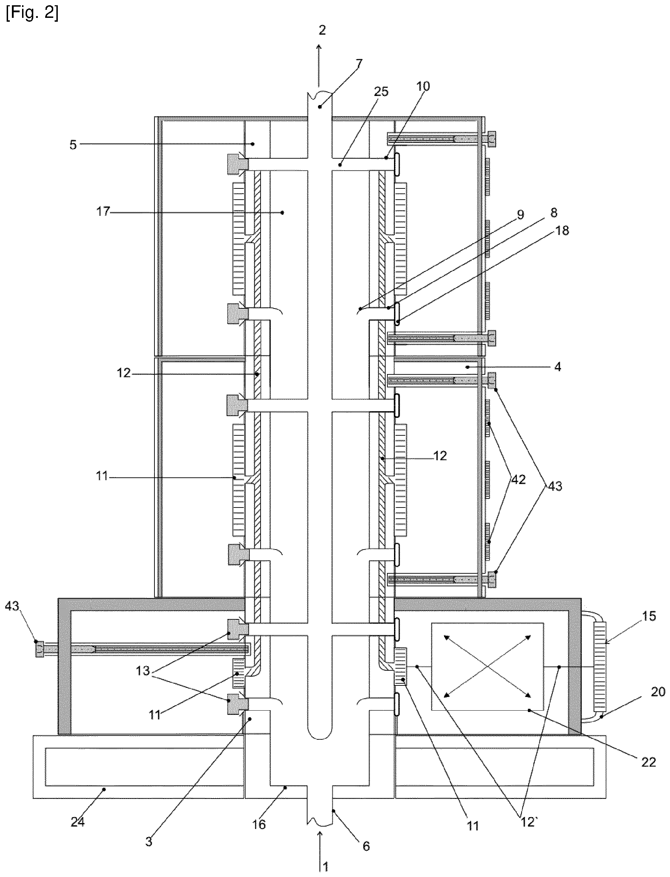

The air inlet tube (6) is arranged connected to a tapered section (16). The said tapered section (16) can be conical in order to enhance air flow. The said tapered is arranged connected to an outside tube (17), the said outside tube (17) having a diameter D171. This change in the diameter of the incoming cold air is shown in Fig 2. The air outlet tube (7) is placed, at least partially, inside the outside tube (17), as it can be seen in Fig 2. In order to maintain a constant flow passage section, the diameter of the air outlet tube (7) can vary increasingly starting from a tip extremity, which is situated in the area of the tapered section (16). The diameter of the air outlet tube (7) can increase progressively on part or on the whole length of the outside tube (17). This provides the advantage of progressively reducing the passage section of the cold air flowing in and to progressively increase the passage section of hot air flowing out from the rack. Therefore, the progressive increase of hot evacuation air section and the progressive decrease of cold income air section is achieved by varying the diameter D71 between 0 and its maximum. The outside tube (17) starts from the top side of the highest base (3) and ends where it is connected with the air exhaust (2).

The rack cooling structure of the invention comprises also a plurality of equidistant radially positioned cold air holes (8) arranged on the said outside tube (17), each cold air hole (8) having a corresponding stream conductor (9), the said air stream conductor (9) being arranged on the inside of the said outside tube (17). The air stream conductors (9) can enhance the cold incoming air penetration through the cold air holes (8) by providing an air intake downwards, knowing that the cold air flow in oriented upwards. The air stream conductors (9) can preferably be arranged in the shape of a curved tube, as seen on Fig 2. The air outlet tube (7) is provided with a plurality of equidistant radially positioned hot air holes (10). Each hot air hole (10) is connected to a tube traversing the inside section of the outside tube (17). The traversing tube convey the hot air from the electronic device (4) to the air outlet tube (7), see Fig 2.

In order to maintain a constant flow passage section through all connecting segments (5) from bottom up to top, one may use properly calculated diameters D171 of outside tube (17) and D71 of inside tube (7) to reduce the pressure loss due to the number of cold-air holes (8) and hot-air holes (10) along the tubes. For example, a rack cooling structure using 3 base segments and 20 connecting segments may use a larger diameter D171 outside tube (17) and D71 of the inside tube (7) compared to a case when a rack cooling structure uses only 1 base segment and 3 connecting segments.

The rack cooling structure of the invention comprises also a plurality of equidistant radially positioned electrical connectors (11) being arranged on the said at least one connecting segment (5).

In an embodiment, the outside tube (17) might be formed from the juxtaposition of a plurality of connecting segments (5).

The rack cooling structure of the invention comprises also a plurality of equidistant radially positioned connectors (11) being arranged on the said at least one base segment (3). The connectors (11) from the base segment (3) may be identical or different to connectors (11) from connecting segments (5).

The rack cooling structure of the invention comprises also at least one base segment (3), each said electrical connector (11) being connected to an electrical cable (12), the said electrical cable (12) being connected to all or some of the other connectors (11). The at least one cable (12) can be arranged to connect at least one of the plurality of connectors (11) from the base segment (3) with at least one of the plurality of connectors (11) from connecting segments (5).

The said air inlet tube (6), the said air outlet tube (7), the said at least one base (3), the said at least one connecting segment (5), the said tapered section (16) and the said outside tube (17) are all arranged coaxial to each other on a vertical axis. Consequently, the rack has an outside cylindrical general shape, with a vertical axis and with a superposition of one or more base segments (3) on top of which there are superposed one or more connecting segments (5). On the inside of the rack, air flows from the air inlet tube (6) to the tapered section (16) and further the said outside tube (17), while the hot air is evacuated through the air outlet tube (7).

The at least one connecting segment (5) comprises a plurality of circular arc shaped interfaces. Each interface comprises, in the order, following an axial vertical, at least one cold air hole (8), at least one electrical or fiber connector (11), at least one hot air hole (10) and at least one connecting means (14). The connecting means (14) can be a threaded hole or any mean suitable to connect an electronic device (4) with a connecting segment (5). Each interface is thus in the shape of a rectangular cylindrical arc with its longer length following the vertical axis. Consequently, the electronic devices (4) are mounted in a general vertical manner on the interfaces, which ensure an optimized use of the volume around each connecting segment (5). Preferably each interface comprises in the axial vertical order one or two cold air holes (8), an electrical connector (11), one or two hot air holes (10) and one or two connecting means (14). Depending on the size and / or the power of the electronic device connected onto the interface, the quantity of calories to be evacuated can differ, therefore the skilled person can adapt the number of cold air holes (8) and the number or hot air holes (10) and their diameters in order to be used for each interface.

The at least one base segment (3) comprises a plurality of circular arc shaped interfaces, each interface comprising at least one electrical or fiber connector (11), at least one electrical or fiber connector (15) and at least one connecting means (14). Each interface, by means of using cable (12) and/or a specialized electro-optical device (22) for multiplexing the pins of the internal connector (11) with connector (15) for external world wiring.

In an embodiment, the cable (12) is arranged attached or integral with the outside tube (17). This means that the cable (12) can be situated within the inside of the outside tube (17) or can be included in the side of the outside tube (17). Alternatively, the cable (12) can be molded integrally with the outside tube (17). Furthermore, the cable (12) comprises electrical wires and/or optical fiber. In fact, the cable (12) will convey electrical power and data signals.

Advantageously, each cable (12) can be realized as a hollow coat insulator comprising a plurality of wires able to provide electrical power and wires suitable to exchange analog and digital data.

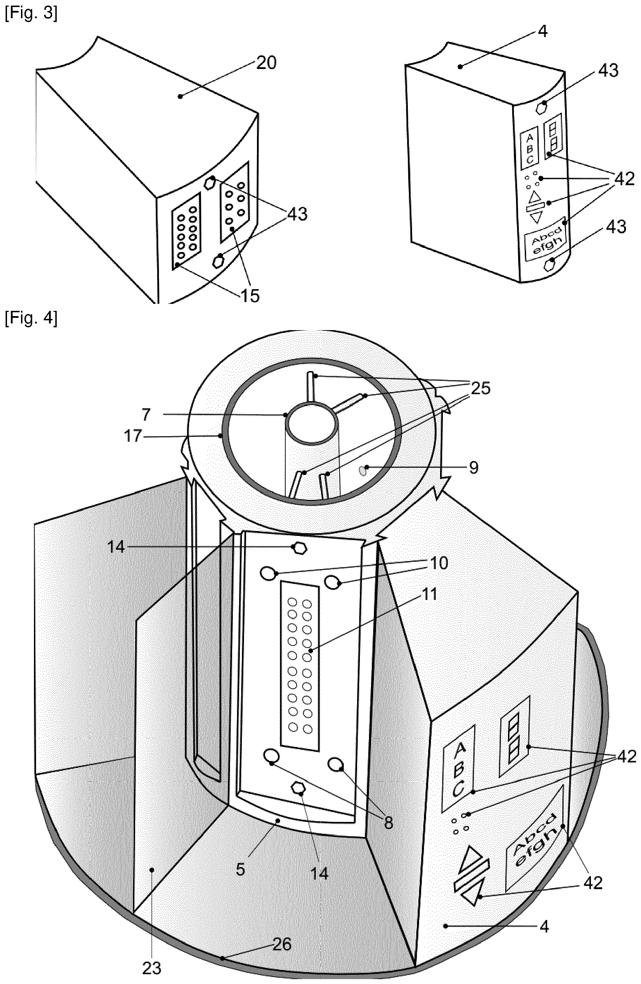

In the embodiment where cable (12) is attached to outside tube (17), there might be an open space between the outside tube (17) and the inside face of connecting segment (5), this open space being visible in Fig 4.

The cable (12) may consist of a beam of traces made of conductive material built/protruded within the outside tube (17) made of non-conductive material.

In an embodiment, the said outside tube (17) comprises extruded protuberances which builds connectors (11) that uses conductive wires and/or optical fibers.

In an embodiment, the rack cooling structure further comprises at least one base module (20), the said least one base module (20) being arranged connected to one of said plurality of connectors (11), the said at least one base module (20) comprising a multiplexing module (22) and at least one connector (15). The said at least one base module (20) is preferably formed as a variable arc segment dimension, the said connectors (15) being arranged on an radial face of the said at least one base module (20), the multiplexing module being arranged to multiplex the signals between the said plurality of connectors (11) and the said connector (15), the multiplexing module being programmable mapped by software and/or hardware means. This embodiment uses short wires between a plurality of electronic devices (4) and between any electronic device (4) and a general electrical connector (15), therefore reducing the power loss due to the lengthy cables used in the prior art devices.

When a device (4) plugs into an interface of the connecting segment (5) of the rack, it connects the electronic device it holds to at least one connector (11). Next, when a base module (20) plugs into a base segment (3) of the rack, it connects one or more electrical or optical-fiber connectors (15) faced outside the segment to an internal connector (11). As an advantage, the electronic devices (4) can easily be plugged in or replaced without having to mount or to remove any electrical cable because all cables that interface the devices with external world are located in one-place, at the bottom of the rack, within base modules (20).

In an embodiment, the general electrical connectors (15) are arranged inside or outside the said at least one base segment (3). The actual position can be set depending on how the rack is installed in the room: If the power and data cables are arranged in the floor, the base segments (3) can be situated underneath the floor-level and hence, the electrical connectors (15) of any base segment (3) will have their wires connected to external world hidden, underfloor. Otherwise, if the power and data cables are arranged in a visible manner in the room, the base segments (3) may sit above the floor level. The general electrical connectors (15) comprise connectors suitable for electrical wires and / or fibers

In an embodiment, the rack cooling structure further comprises a plurality of air sealing means (18) arranged with the radially positioned cold air holes (8) and with the radially positioned hot air holes (10). The air sealing means (18) can be in the shape of rings, possibly made from rubber.

The air sealing means (18) can advantageously be arranged on the circumferential side of the connecting segments (5), in the area of each interface. In this case, the air sealing means (18) are arranged to seal the air circulation between connecting segments (5) and devices (4).

The air sealing means (18) can advantageously also be arranged on the circumferential side of the base segment (3), in the area of each interface. In this case, the air sealing means (18) are arranged to seal the air circulation between base segment (3) and base modules (20).

In an embodiment, the outside tube (17) is composed from a juxtaposition of a plurality of connecting segments (5) and further comprising a floor connection means, the said floor connection means being arranged below the lowest from the said at least one base segments (3) or between one of the said at least one base segment (3) and one of the said at least one connecting segment (5). An example of floor connection means can be seen in the lower part of Fig 2. In this example, floor connection means (24) is situated in the lower part of the rack cooling structure.

In an embodiment of a rack structure may use a support (24) to hold the weight of the entire rack that sits at the bottom of the structure like in Fig.1. Another embodiment of the rack structure may use a support made of the floor structure that sits between top-most base-module (20) and bottom-most de device (4).

In an embodiment, the internal mapping of all signals between electrical connectors (15) located in a base segment (3) and each electronic device (4) located in connecting segment (5) can be achieved by means of a software interface which configures electronic devices from base segments (3) to build the proper signal circuits, thus reducing the mounting process and time.

In an embodiment, the rack cooling structure further comprises a blower fan arranged within the air intake (1) and / or blower fan arranged within the air exhaust (2), preferably comprising a cooling means. Thanks to the efficient rack design, the cooling effect can be achieved with a single fan situated within the air intake (1) or within the air exhaust (2). If the size of the rack, the room temperature or other aggravating factors needs an increased wind flow, two fans can be used within the air intake (1) and within the air exhaust (2). Alternatively, a cooling means can also be used. The cooling means can comprise an air conditioner. However, according to the conventional rack cooling structure, when many racks are installed, a rack farther from the air conditioner cannot receive sufficient cold air. For this reason, there exists a problem that measures, such as using a large sized air conditioner and reducing the number of apparatuses in a rack, are needed. In order to prevent such a problem, the cooling means can advantageously be arranged within the rack, more precisely within the air intake (1).

In an embodiment, the outside tube (17) is composed from a juxtaposition of a plurality of connecting segments (5), the diameter D171 being similar to diameter D51. In case where the outside tube (17) is made from the juxtaposition of the connecting segments (5), the diameter D171 equals sensibly the diameter D51.

In an embodiment of a base (3) or connecting segment (5) may use vertical blades (23) and/or horizontal discs (26) that will hold the weight of the other segments that sits above. This might be the case when the cooling structure needs to accommodate heavy computer devices (4), as illustrated in Fig 4.

In an embodiment of a base (3) or connecting segment (5) may use snap-on or treaded mechanism (14) to fix and hold a device (4) or base module (20). Hence, a device (4) or base module (20) has a plurality of screws or snap-on fingers (43) to fix and latch itself to the connecting or base segment it holds, as illustrated in Fig 3.

In an embodiment of a base module (20) may connect signals between connectors (11) and (15) by means of internal cables (12') or direct board-to-connector means, as illustrated in Fig 2.

Further, an electronic device (4), is suitable to be connected in the rack cooling structure. The electronic device (4) have a circular cylindrical sector shape with internal and external diameters D41 and D42, the electronic device (4) preferably comprising visual signs (42) such as LCD or other displays/LEDs, and/or buttons arranged on an external face, the said at least one electronic device (4) comprising at least one electrical connector suitable to be connected with the electrical connector (11), at least an air inlet opening suitable to be connected with at least one cold air hole (8), at least an outlet air opening suitable to be connected with at least one hot air hole (10), at least one holding means suitable to be connected with the at least one connecting means (14), the said electronic device (4) being air tight. The at least one holding means can be in the form of a screw or any form of means suitable to be connected with the at least one connecting means. The at least one connecting means (14) can be in the form of threaded holes or any suitable mean which can cooperate with the holding means in order to hold the electronic device (4) in place.

Advantageously, a tube (25) connects the at least one hot air hole (10) to the air outlet tube (7), as illustrated in Fig 2.

In an embodiment, diameter D42 of the whole set of devices (4) assembled in a circle onto a connected segment (5) might be inferior or sensibly similar to diameter D200 of the whole set of base modules (20) assembled in a circle onto a base segment (3), as seen in Fig 1 and Fig 2.

The air flow circulating inside the electronic device (4) follow an upwardly path, from the at least one cold air hole (8) up to the at least one hot air hole (10). This inside air flow circulating exchanges calories between the heat emitting devices inside the electronic device (4) and the cold air, which gets warmer while flowing through the air channels provided in the electronic device (4). Therefore, the electronic device (4) should be provided with a specific inside air circulation path in order to enhance the temperature exchange.

Further, a dummy device comprising at least one plug (13) can be arranged to be connected with the at least one air cold air hole (8), at least one plug (13) suitable to be connected with the at least one hot air holes (10). The dummy device comprises preferably at least one holding means, the said at least one holding means being suitable to be connected with the at least one connecting means (14).

The dummy device can be placed in the area of connecting segment (5), where there is no electronic device (4). Consequently, the cooling air flow is channeled only through the electronic devices (4) plugged in the rack. There is no direct contact between the air flows inside the core of the rack and the environment air in the room. When all the interfaces of a segment (5) are connected with electronic devices (4), the operator can easily superpose one more segment on the top of the one which is full of electronic devices (4). However, if there are available interfaces, which are not connected to electronic devices (4), a dummy device is plugged in. As a rule, each interface should be connected to an electronic device (4) or a dummy device in order to ensure air tightness.

The dummy device can also be placed in the area of base segment (3), where there is no base module (20). Consequently, the cooling air flow is channeled only through the base modules (20) plugged in the rack. There is no direct contact between the air flows inside the core of the rack and the environment air in the room. When all the interfaces of a base segment (3) are connected with base modules (20), the operator can easily superpose one more segment on the top of the one which is full of base modules (20). However, if there are available interfaces, which are not connected to base modules (20), a dummy device is plugged in. As a rule, each interface should be connected to a base modules (20) or a dummy device in order to ensure air tightness.

## Claims

1. Rack cooling structure comprising an air intake (1) connected to an air inlet tube (6) of substantially cylindrical shape having a diameter D61, an air exhaust (2) connected to an air outlet tube (7) of substantially cylindrical shape having a diameter D71, at least one base segment (3) having a substantially cylindrical shape with a diameter D31, at least one connecting segment (5) having a substantially cylindrical shape with a diameter D51, the said air inlet tube (6) being connected to a tapered section (16), the said tapered section (16) being connected to an outside tube (17), the said outside tube (17) having a diameter D171, a plurality of equidistant radially positioned cold air holes (8) arranged on the said outside tube (17), each cold air hole (8) being arranged connected to a corresponding air stream conductor (9), the said air stream conductor (9) being arranged on the inside of the said outside tube (17), the said air outlet tube (7) having a plurality of equidistant radially positioned hot air holes (10), a plurality of equidistant radially positioned connectors (11) being arranged both on the said at least one connecting segment (5) and on the said at least one base segment (3), at least one cable (12), the said at least one cable (12) being arranged to connect at least two of the plurality of connectors (11), **characterized in that** the said air inlet tube (6), the said air outlet tube (7), the said at least one base segment (3), the said at least one connecting segment (5), the said tapered section (16) and the said outside tube (17) are all arranged coaxial to each other on a vertical axis, the said at least one connecting segment (5) comprises a plurality of circular arc shaped interfaces, each interface comprising at least one of the cold air holes (8), at least one connector (11), at least one connecting means (14) and at least one of the hot air holes (10), wherein when a device (4) plugs into the interface of the connecting segment (5) of the rack, it connects the electronic device (4) it holds to the at least one connector (11).

2. The rack cooling structure according to any one of previous claims, in which the said at least one base segment (3) comprises a plurality of circular arc shaped interfaces, each interface comprising at least one of the cold air holes (8), at least one connector (11), at least one connecting means (14) and at least one of the hot air holes (10).

3. The rack cooling structure according to any one of the previous claims, in which the cable (12) is arranged attached or integral with the outside tube (17) and the cable (12) comprises electrical wires and/or optical fiber.

4. The rack cooling structure according to any one of previous claims, further comprising at least one base module (20), the said at least one base module (20) having an exterior diameter D200 and being arranged connected to one of the said plurality of connectors (11), the said at least one base module (20) comprising a multiplexing module (22) and at least one connector (15), the said at least one connector (15) being arranged on an radial face of the said at least one base module (20), the multiplexing module (22) being arranged to multiplex the signals between at least one of the said plurality of connectors (11) and the said at least one connector (15), the multiplexing module (22) being programmable mapped by software and/or hardware means.

5. The rack cooling structure according to any one of previous claims, further comprising a plurality of air sealing means (18) arranged with the radially positioned cold air holes (8) and with the radially positioned hot air holes (10).

6. The rack cooling structure according to any one of previous claims, in which the outside tube (17) is composed from a juxtaposition of a plurality of connecting segments (5) and further comprising a floor connection means, the said floor connection means being arranged below the lowest from the said at least one base segments (3) or between one of the said at least one base segment (3) and one of the said at least one connecting segment (5).

7. The rack cooling structure according to any one of previous claims, further comprising a blower fan arranged within the air intake (1) and / or blower fan arranged within the air exhaust (2), preferably comprising a cooling means.

## Patentansprüche

1. Kühlstruktur für ein Rack, umfassend einen Lufteinlass (1), der mit einem Lufteinlassrohr (6) verbunden ist, das eine im Wesentlichen zylindrische Form mit einem Durchmesser D61 aufweist, einen Luftauslass (2), der mit einem Luftauslassrohr (7) verbunden ist, das eine im Wesentlichen zylindrische Form mit einem Durchmesser D71 aufweist, mindestens ein Basissegment (3), das eine im Wesentlichen zylindrische Form mit einem Durchmesser D31 aufweist, mindestens ein Verbindungselement (5), das eine im Wesentlichen zylindrische Form mit einem Durchmesser D51 aufweist, wobei das genannte Lufteinlassrohr (6) mit einem konischen Abschnitt (16) verbunden ist, der genannte konische Abschnitt (16) mit einem Außenrohr (17) verbunden ist, wobei das genannte Außenrohr (17) einen Durchmesser D171 aufweist, eine Vielzahl von radial gleichmäßig angeordneten Kaltluftöffnungen (8) aufweist, die am genannten Außenrohr (17) angeordnet sind, jede Kaltluftöffnung (8) ist mit einem entsprechenden Luftstromleiter (9) verbunden, wobei der genannte Luftstromleiter (9) innerhalb des genannten Außenrohrs (17) angeordnet ist, das genannte Luftauslassrohr (7) eine Vielzahl von radial gleichmäßig angeordneten Warmluftöffnungen (10) aufweist, eine Vielzahl von radial gleichmäßig angeordneten Anschlüssen (11) sowohl am genannten mindestens einen Verbindungselement (5) als auch am genannten mindestens einen Basissegment (3) angeordnet ist, mindestens ein Kabel (12), wobei das genannte mindestens eine Kabel (12) so angeordnet ist, dass es mindestens zwei der Vielzahl von Anschlüssen (11) verbindet, **dadurch gekennzeichnet, dass** das genannte Lufteinlassrohr (6), das genannte Luftauslassrohr (7), das genannte mindestens eine Basissegment (3), das genannte mindestens eine Verbindungselement (5), der genannte konische Abschnitt (16) und das genannte Außenrohr (17) alle koaxial zueinander auf einer vertikalen Achse angeordnet sind, wobei das genannte mindestens eine Verbindungselement (5) eine Vielzahl von kreisbogenförmigen Schnittstellen umfasst, jede Schnittstelle umfasst mindestens eine der Kaltluftöffnungen (8), mindestens einen Anschluss (11), mindestens ein Verbindungsmittel (14) und mindestens eine der Warmluftöffnungen (10), wobei, wenn ein Gerät (4) in die Schnittstelle des Verbindungselements (5) des Racks eingesteckt wird, es das elektronische Gerät (4), das es enthält, mit dem mindestens einen Anschluss (11) verbindet.

2. Die Kühlstruktur für ein Rack gemäß einem der vorhergehenden Ansprüche, bei der das genannte mindestens eine Basissegment (3) eine Vielzahl von kreisbogenförmigen Schnittstellen umfasst, wobei jede Schnittstelle mindestens eine der Kaltluftöffnungen (8), mindestens einen Anschluss (11), mindestens ein Verbindungsmittel (14) und mindestens eine der Warmluftöffnungen (10) umfasst.

3. Die Kühlstruktur für ein Rack gemäß einem der vorhergehenden Ansprüche, bei der das Kabel (12) am oder im Außenrohr (17) befestigt oder integriert ist, wobei das Kabel (12) elektrische Leitungen und/oder optische Fasern umfasst.

4. Die Kühlstruktur für ein Rack gemäß einem der vorhergehenden Ansprüche, ferner umfassend mindestens ein Basismodul (20), wobei das genannte mindestens eine Basismodul (20) einen Außendurchmesser D200 aufweist und mit einem der Vielzahl der genannten Anschlüsse (11) verbunden ist, wobei das genannte mindestens eine Basismodul (20) ein Multiplexermodul (22) und mindestens einen Anschluss (15) umfasst, wobei der genannte mindestens eine Anschluss (15) auf einer radialen Fläche des genannten mindestens einen Basismoduls (20) angeordnet ist, wobei das Multiplexermodul (22) so angeordnet ist, dass es die Signale zwischen mindestens einem der genannten Anschlüsse (11) und dem genannten mindestens einen Anschluss (15) multiplexiert, wobei das Multiplexermodul (22) durch Software- und/oder Hardwaremittel programmierbar ist.

5. Die Kühlstruktur für ein Rack gemäß einem der vorhergehenden Ansprüche, ferner umfassend eine Vielzahl von Luftabdichtungsmitteln (18), die mit den radial angeordneten Kaltluftöffnungen (8) und den radial angeordneten Warmluftöffnungen (10) angeordnet sind.

6. Die Kühlstruktur für ein Rack gemäß einem der vorhergehenden Ansprüche, bei der das Außenrohr (17) aus einer Juxtaposition einer Vielzahl von Verbindungselementen (5) besteht und ferner ein Bodenkonnektionsmittel umfasst, wobei das genannte Bodenkonnektionsmittel unter dem untersten der genannten mindestens einen Basissegmente (3) oder zwischen einem der genannten mindestens einen Basissegmente (3) und einem der genannten mindestens einen Verbindungselemente (5) angeordnet ist.

7. Die Kühlstruktur für ein Rack gemäß einem der vorhergehenden Ansprüche, ferner umfassend einen Lüfter, der innerhalb des Lufteinlasses (1) und/oder einen Lüfter, der innerhalb des Luftauslasses (2) angeordnet ist, vorzugsweise ein Kühlmittel umfassend.

## Revendications

1. Structure de refroidissement pour rack comprenant une prise d'air (1) reliée à un tube d'admission d'air (6) de forme sensiblement cylindrique ayant un diamètre D61, une évacuation d'air (2) reliée à un tube d'échappement d'air (7) de forme sensiblement cylindrique ayant un diamètre D71, au moins un segment de base (3) de forme sensiblement cylindrique avec un diamètre D31, au moins un segment de connexion (5) de forme sensiblement cylindrique avec un diamètre D51, ledit tube d'admission d'air (6) étant connecté à une section conique (16), ladite section conique (16) étant connectée à un tube extérieur (17), ledit tube extérieur (17) ayant un diamètre D171, une pluralité de trous d'air froid (8) positionnés radialement et à égale distance sur ledit tube extérieur (17), chaque trou d'air froid (8) étant relié à un conducteur de flux d'air correspondant (9), ledit conducteur de flux d'air (9) étant disposé à l'intérieur dudit tube extérieur (17), ledit tube d'échappement d'air (7) comprenant une pluralité de trous d'air chaud (10) positionnés radialement et à égale distance, une pluralité de connecteurs (11) également positionnés radialement étant disposés à la fois sur ledit au moins un segment de connexion (5) et sur ledit au moins un segment de base (3), au moins un câble (12), ledit au moins un câble (12) étant configuré pour connecter au moins deux des connecteurs (11) de la pluralité, **caractérisé en ce que** ledit tube d'admission d'air (6), ledit tube d'échappement d'air (7), ledit au moins un segment de base (3), ledit au moins un segment de connexion (5), ladite section conique (16) et ledit tube extérieur (17) sont tous disposés coaxialement les uns par rapport aux autres sur un axe vertical, ledit au moins un segment de connexion (5) comprenant une pluralité d'interfaces en arc de cercle, chaque interface comprenant au moins un trou d'air froid (8), au moins un connecteur (11), au moins un moyen de connexion (14) et au moins un trou d'air chaud (10), dans lequel lorsqu'un dispositif (4) est branché sur l'interface du segment de connexion (5) du rack, il connecte le dispositif électronique (4) qu'il contient à l'au moins un connecteur (11).

2. La structure de refroidissement pour rack selon l'une quelconque des revendications précédentes, dans laquelle ledit au moins un segment de base (3) comprend une pluralité d'interfaces en arc de cercle, chaque interface comprenant au moins un desdits trous d'air froid (8), au moins un connecteur (11), au moins un moyen de connexion (14) et au moins un desdits trous d'air chaud (10).

3. La structure de refroidissement pour rack selon l'une quelconque des revendications précédentes, dans laquelle ledit câble (12) est disposé fixé ou intégré audit tube extérieur (17), ledit câble (12) comprenant des fils électriques et/ou des fibres optiques.

4. La structure de refroidissement pour rack selon l'une quelconque des revendications précédentes, comprenant en outre au moins un module de base (20), ledit au moins un module de base (20) ayant un diamètre extérieur D200 et étant connecté à l'un desdits connecteurs (11), ledit au moins un module de base (20) comprenant un module de multiplexage (22) et au moins un connecteur (15), ledit au moins un connecteur (15) étant disposé sur une face radiale dudit au moins un module de base (20), le module de multiplexage (22) étant configuré pour multiplexeur les signaux entre au moins un desdits connecteurs (11) et ledit au moins un connecteur (15), ledit module de multiplexage (22) étant configuré programmable par des moyens logiciels et/ou matériels.

5. La structure de refroidissement pour rack selon l'une quelconque des revendications précédentes, comprenant en outre une pluralité de moyens d'étanchéité d'air (18) disposés au niveau des trous d'air froid (8), qui sont disposés radialement et au niveau des trous d'air chaud (10), qui sont positionnés radialement.

6. La structure de refroidissement pour rack selon l'une quelconque des revendications précédentes, dans laquelle le tube extérieur (17) est composé d'une juxtaposition d'une pluralité de segments de connexion (5), comprenant en outre un moyen de connexion au sol, ledit moyen de connexion au sol étant disposé sous le segment de base (3) le plus bas parmi ledit au moins un segment de base (3) ou entre l'un desdits au moins un segment de base (3) et l'un desdits au moins un segment de connexion (5).

7. La structure de refroidissement pour rack selon l'une quelconque des revendications précédentes, comprenant en outre un ventilateur disposé dans la prise d'air (1) et/ou un ventilateur disposé dans l'évacuation d'air (2), de préférence comprenant un moyen de refroidissement.
